# EUROPEAN PATENT APPLICATION

(11) **EP 4 481 832 A1**
(43) Date of publication of application: **25.12.2024**
(21) Application number: 23306009.4
(22) Date of filing: 23.06.2023
(51) Int. Cl.: H01L 31/0236

(54) **SOLAR ROOFING PANEL WITH TEXTURED FRONT SURFACE AND ROOFING SYSTEM**

(71) Applicant: CertainTeed LLC, Malvern, PA 19355 (US)
(72) Inventor: KARA, Vural, Northborough, 01532 (US); MIMOUN, Emmanuel, 93303 Aubervilliers (FR); LOOMIS, Garrett, Northborough, 01532 (US); AMID, Hooman, Northborough, 01532 (US)
(74) Representative: Murgitroyd & Company

(57) **Abstract**

The present disclosure relates generally to roofing systems, for example, suitable for covering the roof of a house or other building. The present disclosure relates more particularly to a roofing panel including a back layer, photovoltaic cells disposed over the back layer; and a light transmissible front layer. The front layer has a front surface and a rear surface. The front surface includes a surface texture comprising a macro-texture and a micro-texture identified using a roughness filter cut-off of 800 µm. The macro-texture includes a plurality of ridges that are substantially aligned with a first direction. The micro-texture has an arithmetical mean roughness (Ra) of at least 3 µm. The macro-texture has a texture aspect ratio below 0.05.

## Description

### BACKGROUND OF THE DISCLOSURE

### 1. Field of the Disclosure

The present disclosure relates generally to roofing systems, for example, suitable for covering the roof of a house or other building. The present disclosure relates more particularly to a roofing panel with a textured surface.

### 2. Technical Background

Demand for renewable energy sources, such as solar, wind, and hydropower, continues to grow. Accordingly, the use of photovoltaic cells on roofs is becoming increasingly common, in order to utilize solar energy within buildings and homes. A conventional technique for utilizing photovoltaic cells on roofs is to secure solar panels on top of a complete and enclosed roof system. This technique is effective and has been popular because it allows the solar panels to be added to a roof and to continue utilizing the existing roof structure.

With certain roof designs, the roof is visible from the ground, such as with sloped roofs. In these cases, any solar panels placed on top of the roof will also be visible from the ground. In many instances, the inclusion of solar panels on top of an existing roof structure is inconsistent with the original architectural aesthetic of the building or house, and may be considered undesirable.

Another alternative for utilizing photovoltaic cells on a roof is to include the photovoltaic cells within the roofing system itself, such as in roofing panels or shingles applied over the roof. Such a system allows for a more consistent aesthetic over the surface of the roof compared with systems that include solar panels over the roofing structure. Therefore, there is ongoing interest in providing a roofing system including solar roofing panels with improved aesthetics.

### SUMMARY OF THE DISCLOSURE

In one aspect, the present disclosure provides a roofing panel comprising:
a back layer;
photovoltaic cells disposed over the back layer; and
a light transmissible front layer having a front surface and a rear surface, wherein the front surface includes a surface texture comprising a macro-texture and a micro-texture identified using a roughness filter cut-off of 800 µm, the macro-texture including a plurality of ridges that are substantially aligned with a first direction, and the micro-texture having an arithmetical mean roughness (Ra) of at least 3 µm.
wherein the macro-texture has a texture aspect ratio below 0.05.

In another aspect, the disclosure provides a roofing panel system comprising:
a plurality of roofing panels arranged on a support structure, each of the roofing panels comprising:
a back layer;
photovoltaic cells disposed over the back layer; and
a light transmissible front layer having a front surface and a rear surface, wherein the front surface includes a surface texture comprising a macro-texture and a micro-texture identified using a roughness filter cut-off of 800 µm, the macro-texture including a plurality of ridges that are substantially aligned with a first direction, and the micro-texture having an arithmetical mean roughness (Ra) of at least 3 µm.
wherein the macro-texture has a texture aspect ratio below 0.05.

Additional aspects of the disclosure will be evident from the disclosure herein.

### BRIEF DESCRIPTION OF THE DRAWINGS

The accompanying drawings are included to provide a further understanding of the methods and devices of the disclosure, and are incorporated in and constitute a part of this specification. The drawings are not necessarily to scale, and sizes of various elements may be distorted for clarity. The drawings illustrate one or more embodiment(s) of the disclosure, and together with the description serve to explain the principles and operation of the disclosure.
FIG. 1 is a schematic cross-sectional view of a portion of a roofing panel according to an embodiment of the disclosure;
FIG. 2 is an image of a roofing panel according to an embodiment of the disclosure;
FIG. 3 is a detailed view of the surface of the roofing panel of FIG. 2;
FIG. 4 is a detailed view of a surface of a roofing panel according to another embodiment of the disclosure;
FIG. 5 is a detailed view of a surface of a roofing panel according to another embodiment of the disclosure;
FIG. 6 is a chart showing the slope distributions of the surfaces of FIGS. 4 and 5; and
FIG. 7 is a roofing system according to an embodiment of the disclosure.

### DETAILED DESCRIPTION

As described above, the present inventors have determined that a roofing system including solar roofing panels with improved aesthetics would be attractive to builders and customers.

Accordingly, one aspect of the disclosure is a roofing panel including a back layer, photovoltaic cells disposed over the back layer; and a light transmissible front layer. The front layer has a front surface and a rear surface. The front surface includes a surface texture comprising a macro-texture and a micro-texture identified using a roughness filter cut-off of 800 µm. The macro-texture includes a plurality of ridges that are substantially aligned with a first direction. The micro-texture has an arithmetical mean roughness (Ra) of at least 3 µm. The macro-texture has a texture aspect ratio below 0.05.

Parameters of the textures may be determined using optical profilometry scans of the front surface of the front layer of the panel. Here, the macro-texture was isolated using a Gaussian S filter with a cutoff of 800 µm to remove small wavelength components according to ISO 16610-61. Likewise, the micro-texture was isolated using a Gaussian L filter with a cutoff of 800 µm to remove large wavelength components, again according to ISO 16610-61.

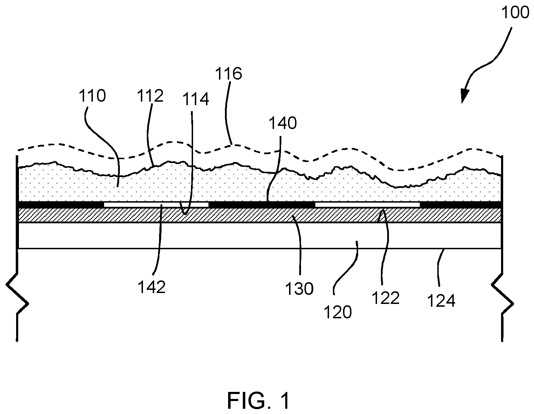

FIG. 1 shows a portion of a cross section of a portion of such a roofing panel 100 that includes a light transmissible front layer 110, a back layer 120, and photovoltaic cells 130. Front layer 110 includes a front surface 112 and a rear surface 114. Likewise, back layer 120 also includes a front surface 122 and a rear surface 124. The photovoltaic cells 130 are positioned between rear surface 114 of the front layer 110 and the front surface 122 of the back layer 120.

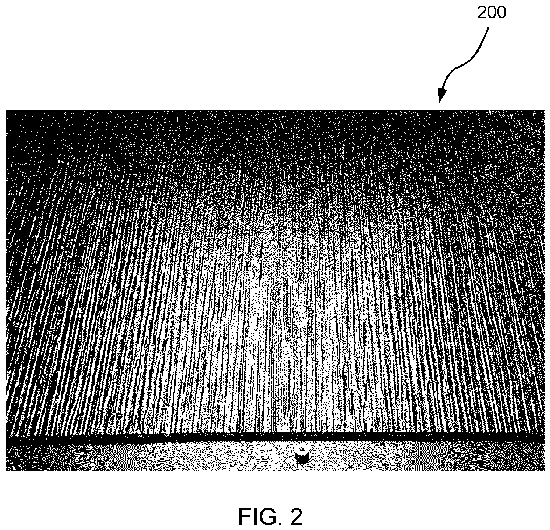

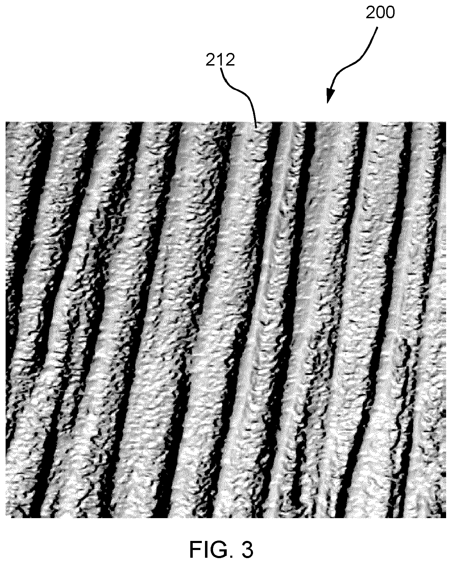

The front surface 112 of front layer 110 is textured and includes both a micro-texture and a macro-texture. The micro-texture, as described herein, is identified using a roughness filter cut-off of 800 µm. The micro-texture is evident in localized variations in the orientation of the surface, which will influence both the reflection and refraction of light hitting the front layer 110. The macro-texture is identified by larger variations in the front surface 112 of front layer 110 and forms a plurality of ridges that extend across the panel (FIGS. 2 and 3). For clarity, the dashed line 116 follows the macro-texture of front surface 112.

The combination of a rough micro-texture with a macro-texture on the front surface of the panel provides beneficial performance of light transmission to the photovoltaic cells while also achieving desirable aesthetics. The rough micro-texture helps to promote light transmission to the photovoltaic cells over a broad range of incidence angles while also avoiding strong specular reflection. However, the three dimensionality of a micro-texture is only visible at close distances. Accordingly, a panel with only a rough micro-texture will have a very uniform manufactured appearance from an appreciable distance, such as from the ground looking up at a roof.

In contrast, the ridges of the macro-texture are visible from further distances and provide a textured aesthetic to the panel. By substantially aligning the ridges in a single direction, the panel can be arranged to conform to the shape of the roof and the surrounding architectural aesthetic. Thus, there are design advantages in having a very low texture aspect ratio, such as no greater than 0.05. On the other hand, some variability in the macro-texture can provide a more natural and less manufactured appearance to the panel. Accordingly, the ridges may vary in height, width and length, and have some variation in direction. For example, a particular ridge may include a slight bend, or may change dimensions, along its length.

FIG. 2 shows an image of a panel 200 according to an embodiment of the disclosure. At this distance, the direction of the ridges of the macro-texture are visible, and it can be seen that all of the ridges are substantially aligned in the same direction that is vertical with respect to the orientation of the image. It is also visible, however, that there is some variation in the path of the ridges, which gives the surface a more natural appearance. For example, some of the ridges meander slightly as they extend across the surface, some of the ridges fork into two ridges, and some of the ridges come to an end. At this resolution, the individual projections and indentations of the micro-texture cannot be identified, though the scattered highlights in some areas of the image illustrate the roughness of the surface.

FIG. 3 shows a more detailed view of the front surface 212 of the panel 200 of FIG. 2. At this resolution, the individual projections and indentations that form the micro-surface are visible. In the embodiment depicted in FIG. 3, the micro-texture has a stochastic pattern, where the projections and indentions follow a random probably distribution. In other embodiments, the micro-texture may be uniform. For example, in some embodiments, the macro-texture includes variations in the ridges, while the micro-texture is formed by a regular and uniform roughness pattern. The resulting combined pattern may still have a degree of variation to provide a natural aesthetic.

In some embodiments, the rear surface of the front layer is flat. For example, in roofing panel 100, as shown in FIG. 1, the rear surface 114 of front layer 110 is flat. Such a construction may occur when the front layer is fabricated in such a way that the texture of the front surface 112 is not transferred to the rear surface 114. In other embodiments, the rear surface of the front layer may also have a texture. For example, in some embodiments, the texture of the rear surface of the front layer may be influenced by the texture, such as the macro-texture of the front surface. In other embodiments, the rear surface may have an independent texture, such as a micro-texture to enhance the light transmission through the front layer. Other configurations of textures on the rear surface of the front layer are also possible. Similarly, in some embodiments, the back layer may include flat surfaces, while in other embodiments, the back layer may include textured surfaces, or one flat surface and one textured surface.

The micro-texture may be in a range of roughness values (Ra) of at least 3 µm. For example, in certain embodiments of the roofing panel as otherwise described herein, the micro-texture has an arithmetical mean roughness (Ra) of at least 5 µm. Roughness values may be calculated according to ISO 21920. A surface with a rougher micro-texture may reduce the impact of the slopes of the macro-texture on the transmission of light through the front layer.

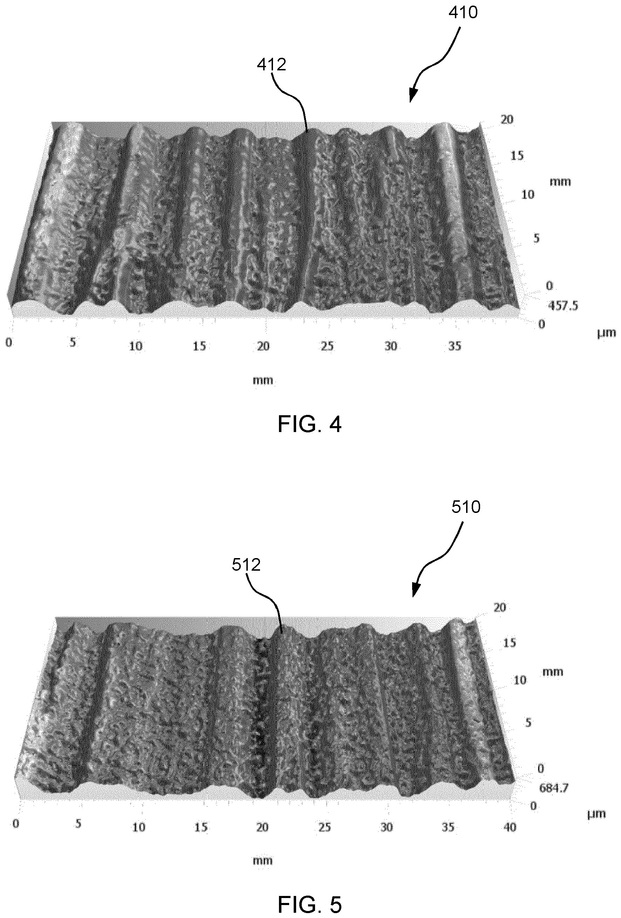

FIG. 4 illustrates an image of a portion of a front surface 412 of a front layer 410 according to an embodiment of the disclosure. The micro-texture of front surface 412 has an arithmetical mean roughness (Ra) of 3.37. FIG. 5 illustrates an image of a portion of a front surface 512 of another front layer 510 according to an embodiment of the disclosure. The micro-texture of panel 500 has an arithmetical mean roughness (Ra) of 5.53.

In certain embodiments of the roofing panel as otherwise described herein, a root mean square height of the ridges of the macro-texture is at least 20 µm, e.g., at least 40 µm, e.g. at least 60 µm. For example, the front surface 412 of FIG. 4 includes ridges that have a root mean square height of 74 µm. In contrast, front surface 512 of FIG. 5 includes ridges that have root mean square height of 114 µm.

In certain embodiments of the roofing panel as otherwise described herein, an average width of the ridges of the macro-texture is at least 2 mm, e.g., at least 3 mm, e.g., at least 4 mm. For example, the front surface 412 of FIG. 4 includes ridges that have an average width of 6.0 mm. In contrast, front surface 512 of FIG. 5 includes ridges that have an average width of 5.6 mm.

The front layer of the embodiment of FIG. 4 has a greater material thickness than the embodiment of FIG. 5. As a result, the front surface 512 of FIG. 5 is more compliant during manufacturing than front surface 412 of FIG. 4. Accordingly, the roughness and the height of the ridges of front surface 512 of front layer 510 is greater than that of front surface 412 of front layer 410. However, the width of the ridges are very similar, as the width characteristics of the texture are more directly influenced by the mold that forms the textured surface, whereas the height characteristics of the texture are also influenced by the thickness of the material and its workability.

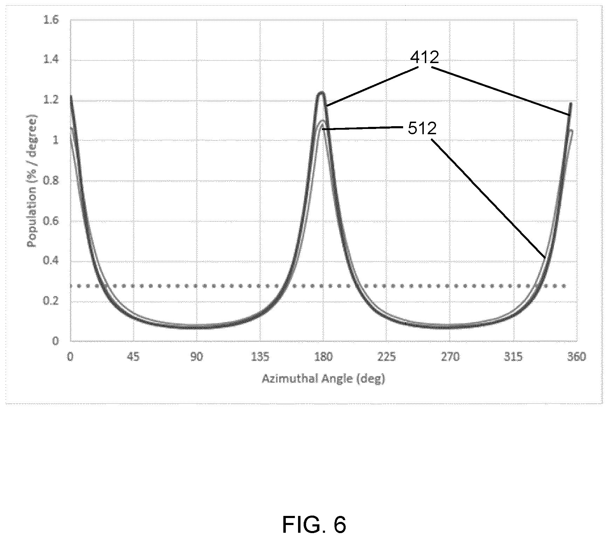

The ridges of the macro-surface of the front layer of the roofing panel are substantially aligned, such that a large portion of the front surface is angled toward a lateral direction that is perpendicular to the direction of the ridges. Accordingly, when the sun is low in the sky in either of the lateral directions, a large portion of the surface of the front layer will guide the light toward the photovoltaic cells. The azimuth angle of the surface quantifies the degree to which the surface of the front layer faces these lateral directions. FIG. 6 shows the distribution of slopes of both the front surface 412 of front layer 410 and the front layer 512 of front layer 510. In particular, FIG. 6 shows the percentage of the slopes of the surfaces 412, 512 at each azimuth angle. In this analysis, the front layer is oriented with the ridges extending in the direction aligned with 90°and 270°.

Configuring the surface so that the slopes are concentrated at certain azimuth angles, for example by forming the ridges that extend across the surface of the front layer, allows the light to be beneficially directed toward the photovoltaic cells under certain lighting conditions, such as grazing lighting conditions. As shown in FIG. 6, in each of the surfaces 412 and 512, the azimuth angles are concentrated around 0°/360° and 180°. As used herein, these directions are described as the "lateral directions."

In some embodiments, the front surface of the front layer is configured so that the vast majority of the slopes on the surface face in opposing lateral directions. For example, in certain embodiments of the roofing panel as otherwise described herein, at least 75% of the macro-texture has an azimuth angle in a range of 0-45°, 135-225°, and 315-360°. In other words, at least 75% of the surface is at least slightly angled toward the 0°/360° and 180° directions, i.e., the lateral directions, rather than the first direction (90° and 270°).

Further, in some embodiments, the front surface of the front layer is configured so that the slopes that substantially face the lateral directions greatly outweigh the slopes that substantially face the first direction (90° and 270°). For example, in certain embodiments of the roofing panel as otherwise described herein, a first portion of the macro-texture has an azimuth angle in a range of 150-220° and a second portion of the macro-texture has an azimuth angle in a range of 60-120°, and the size of the second portion is no more than 20% of the size of the first portion. In other words, the percentage of slopes that are within 30° of the lateral directions (0/360° and 180°) is at least five times greater than the percentage of slopes that are within 30° of the first direction (90° and 270)

In certain embodiments of the roofing panel as otherwise described herein, a transmission efficiency through the light transmissible front layer at an incident angle of 80° is at least 70%. For example, the roofing panel shown in FIGS. 2 and 3 has varied transmission efficiency depending on the angle of incidence of light received by the panel. As with most configurations, the transmission efficiency drops as light becomes more grazing. However, in contrast to most configurations, where the transmission efficiency falls below 70% at an angle of incidence of 80° or greater, the roofing panel shown in FIGS. 2 and 3 has a transmission efficiency of 72.9% at an angle of incidence of 80°. This transmission efficiency was measured where the light was directed perpendicularly to the direction of the ridges. The increased transmission efficiency may be attributed to the high proportion of the front surface of the front layer that is angled laterally, and thus is facing the light when it is received from a grazing angle.

In certain embodiments of the roofing panel as otherwise described herein, the front layer is formed of glass. For example, in some embodiments, the front layer is formed of tempered glass. Tempered glass may provide improved strength and durability resulting from higher resistance to impacts, mechanical stresses and temperature fluctuations. Further, tempered glass has improved safety properties. For example, in the event of an impact that causes layers of the panel to break, the tempered glass may shatter into small, rounded pieces, thereby reducing the risk of large shards of broken glass causing injuries. This can be particularly beneficial in commercial and residential applications of the roofing panels.

In other embodiments, the front layer is formed of another material. For example, in some embodiments, the front layer is formed of another type of glass. Further, in some embodiments, the front layer is formed of a light transmissible polymer.

The front layer, as described herein, is a layer of material in front of the photovoltaic cells that includes a textured surface and is visible. In some embodiments, the front surface of the front layer is exposed to the surrounding environment. In other embodiments, the front layer may be covered with another layer. For example, in some embodiments, the front layer is covered with a coating that impacts the performance of the panel. Such a coating may include an anti-reflective coating. This type of coating can help enhance sunlight absorption by reducing the amount of light that is reflected back into the environment, which can increase the efficiency of the panel.

In certain embodiments of the roofing panel as otherwise described herein, the back layer is formed of glass. For example, in some embodiments, the back layer is formed of tempered glass. In other embodiments, the back layer is formed of another material. For example, in some embodiments, the back layer is formed of a glass-reinforced epoxy resin, such as FR4. In other embodiments, the back layer includes another fiber-reinforced polymer or a layered structure. As examples, the back layer may include any of PVDF, PET, PPE, polyphenylene oxide, polyphenylene sulfide, or other materials. Still, in other embodiments, the back layer is made of another material, such as a ceramic or composite material.

In certain embodiments of the roofing panel as otherwise described herein, the panel further includes a visible coating including a pattern associated with the shape of the photovoltaic cells. The term visible coating, as used herein, refers to a layer of coating that includes a colored surface and is not transparent. However, portions of the visible coating may be obscured, for example by photovoltaic cells or other layers. Such a visible coating layer 140 is shown in FIG. 1. The visible coating layer 140 includes openings 142, through which light may pass unimpeded to the photovoltaic cells 130.

In some embodiments, the visible coating is applied over the rear surface of the front layer. For example, in roofing panel 100, shown in FIG. 1, the visible coating 140 is applied to the rear surface 114 of the front layer 110. In other embodiments, the visible coating is applied to the front surface of the back layer. Still, in other embodiments, the visible coating is applied to the rear surface of the back layer.

In certain embodiments of the roofing system as otherwise described herein, the visible coating includes a pattern associated with the shape of the photovoltaic cells. For example, in some embodiments, the visible coating is provided in a pattern, for example by printing the visible coating, over the front or back layer. The pattern may be provided across the associated front or back layer to cover areas between the photovoltaic cells but include openings in the pattern that align with the photovoltaic cells. In some embodiments, the patterned visible coating is formed in front of the photovoltaic cells and the openings allow light to pass through to the photovoltaic cells. In other embodiments, the patterned visible coating is provided behind the photovoltaic cells, in which case the openings may reduce the amount of material used to form the layer, and avoid unnecessarily providing material for the visible coating in areas that will be obscured by the photovoltaic cells.

In certain embodiments of the roofing panel as otherwise described herein, the visible coating is an inorganic enamel coating. In other embodiments, the visible coating may be formed by another material, such as a pigment-loaded polymer.

In embodiments of the roofing panels described herein, the above-described layers within the roofing panels may be directly secured to one another or secured to one another using intermediate layers, such as adhesive layers. Further still, embodiments of the roofing panels may include additional layers within the roofing panels.

In certain embodiments of the roofing panel as otherwise described herein, the roofing panel has a thickness in a range from 3 mm to 15 mm, e.g., from 3 mm to 9 mm. Other sizes are also possible.

In another aspect, the disclosure provides a roofing panel system that includes a plurality of roofing panels arranged on a support structure. Each of the roofing panels includes a back layer, photovoltaic cells disposed over the back layer, and a light transmissible front layer. The light transmissible front layer has a front surface and a rear surface. The front surface includes a surface texture comprising a macro-texture and a micro-texture identified using a roughness filter cut-off of 800 µm. The macro-texture includes a plurality of ridges that are substantially aligned with a first direction. The micro-texture has an arithmetical mean roughness (Ra) of at least 3 µm. The macro-texture has a texture aspect ratio below 0.05.

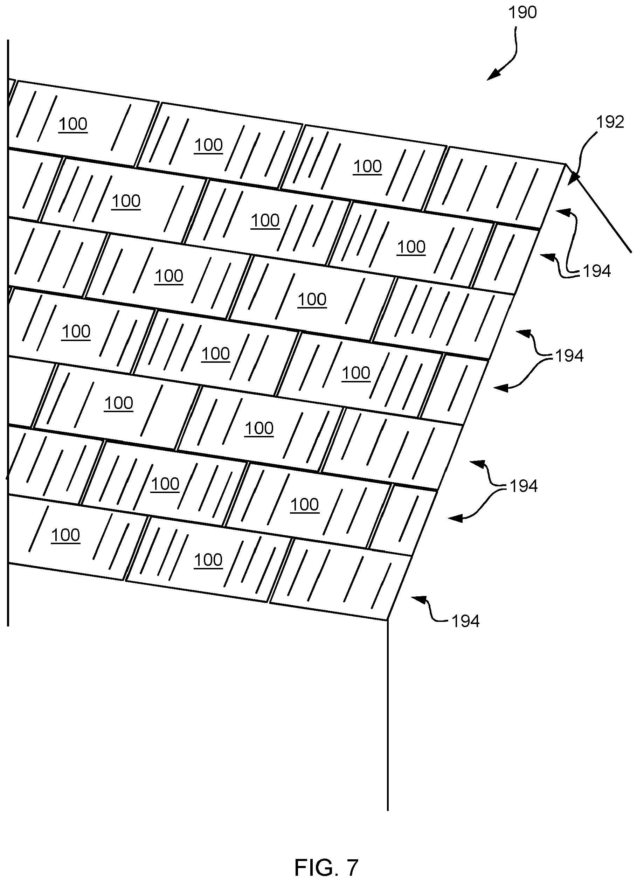

Such a roofing system is shown in perspective view in FIG. 7. Roofing system 190 includes a plurality of roofing panels 100 arranged on a support structure 192. Each of the roofing panels 100 is configured in accordance with the panel of the disclosure, as described in detail above. The ridges of the macro-texture of the front surface are schematically depicted as lines that extend across the front surface of the panel 100.

In certain embodiments of the roofing system as otherwise described herein, the ridges of the plurality roofing panels extend along a slope of the support structure. For example, as schematically depicted in FIG. 7, the ridges of the panels 100 are aligned with the slope of the support structure 192, such that the ridges extend up the slope. This configuration is consistent with typical aesthetics of roofing systems and may also help with drainage of the roofing system. With the ridges extending down the slope of the roof, water falls onto the panels may be guided down toward a gutter at the bottom of the roof.

In certain embodiments of the roofing system as otherwise described herein, the roofing panels are arranged in rows on the support structure. For example, the roofing panels 100 of roofing system 190 are arranged in an array that includes a plurality of rows or courses 194 on support structure 192. In the embodiment of roofing system 190, the roofing panels 100 in each row extend across the support structure. However, in other embodiments, the rows may extend up the slope of the roof. Further, while the roofing panels of each row 194 in roofing system 190 are offset from the roofing panels of a neighboring row, in other embodiments, the roofing panels of neighboring rows may be aligned so as to form a grid. Further still, while the roofing panels 100 of roofing system 190 are flat and rectangular, such that the rows 194 have straight edges, in other embodiments, the roofing panels may have other polygonal shapes or be rounded. Moreover, in some embodiments, the surfaces of the roofing panels may bend or curve.

In certain embodiments of the roofing system as otherwise described herein, the rows overlap along the slope of the support structure. For example, in some embodiments the lower edge of a row of panels that are higher on the roof structure overlap the upper edge of an adjacent row of panels that are lower on the roof structure. As a result, water flowing over the upper row of panels flows onto the lower row of panels, rather than onto the support structure.

Various aspects and embodiments of the disclosure are provided by the following non-limiting set of enumerated embodiments, which may be combined in any number and in any fashion not technically or logically inconsistent.
Embodiment 1. A roofing panel comprising:
   a back layer;
   photovoltaic cells disposed over the back layer; and
   a light transmissible front layer having a front surface and a rear surface, wherein the front surface includes a surface texture comprising a macro-texture and a micro-texture identified using a roughness filter cut-off of 800 µm, the macro-texture including a plurality of ridges that are substantially aligned with a first direction, and the micro-texture having an arithmetical mean roughness (Ra) of at least 3 µm,
   wherein the macro-texture has a texture aspect ratio below 0.05.
Embodiment 2. The roofing panel according to embodiment 1, wherein the micro-texture has an arithmetical mean roughness (Ra) of at least 5 µm.
Embodiment 3. The roofing panel according to embodiment 1 or embodiment 2, wherein an average height of the ridges of the macro-texture is at least 50 µm, e.g., at least 100 µm, e.g. at least 150 µm.
Embodiment 4. The roofing panel according to any of embodiments 1 to 3, wherein an average width of the ridges of the macro-texture is at least 2 mm, e.g., at least 3 mm, e.g. at least 4mm.
Embodiment 5. The roofing panel according to any of embodiments 1 to 4, wherein at least 75% of the macro-texture has an azimuth angle in a range of 0-45°, 135-225°, and 315-360°.
Embodiment 6. The roofing panel according to any of embodiments 1 to 5, wherein a first portion of the macro-texture has an azimuth angle in a range of 150-220° and a second portion of the macro-texture has an azimuth angle in a range of 60-120°, and wherein the size of the second portion is no more than 20% of the size of the first portion.
Embodiment 7. The roofing panel according to any of embodiments 1 to 6, wherein a transmission efficiency through the light transmissible front layer at an incident angle of 80° is at least 70%.
Embodiment 8. The roofing panel according to any of embodiments 1 to 7, wherein the front layer is formed of glass, e.g., tempered glass.
Embodiment 9. The roofing panel according to any of embodiments 1 to 8, wherein the back layer is formed of glass, e.g., tempered glass.
Embodiment 10. The roofing panel according to any of embodiments 1 to 9, further comprising a visible coating including a pattern associated with the shape of the photovoltaic cells.
Embodiment 11. The roofing panel according to any of embodiments 1 to 10, wherein the visible coating is applied over:
   the rear surface of the front layer,
   the front surface of the back layer, or
   the rear surface of back layer.
Embodiment 12. The roofing panel according to embodiment 11, wherein the visible coating is an inorganic enamel coating.
Embodiment 13. The roofing panel according to any of embodiments 1 to 12, wherein the roofing panel has a thickness in a range from 3 mm to 15 mm, e.g., from 3 mm to 9 mm.
Embodiment 14. A roofing panel system comprising:
   a plurality of roofing panels arranged on a support structure, each of the roofing panels comprising:
   a back layer;
   photovoltaic cells disposed over the back layer; and
   a light transmissible front layer having a front surface and a rear surface, wherein the front surface includes a surface texture comprising a macro-texture and a micro-texture identified using a roughness filter cut-off of 800 µm, the macro-texture including a plurality of ridges that are substantially aligned with a first direction, and the micro-texture having an arithmetical mean roughness (Ra) of at least 3 µm.
   wherein the macro-texture has a texture aspect ratio below 0.05.
Embodiment 15. The roofing system according to embodiment 14, wherein the ridges of the plurality roofing panels extend along a slope of the support structure.
Embodiment 16. The roofing system according to embodiment 14 or embodiment 15, wherein the roofing panels are arranged in rows on the support structure.
Embodiment 17. The roofing system according to any of embodiments 14 to 16, wherein the rows overlap along the slope of the support structure.
Embodiment 18. The roofing system according to any of embodiments 14 to 17, wherein the micro-texture has an arithmetical mean roughness (Ra) of at least 5 µm.
Embodiment 19. The roofing system according to any of embodiments 14 to 18, wherein root mean square height of the ridges of the macro-texture is at least 20 µm, e.g., at least 40 µm, e.g. at least 60 µm.
Embodiment 20. The roofing system according to any of embodiments 14 to 19, wherein an average width of the ridges of the macro-texture is at least 2 mm, e.g., at least 3 mm, e.g. at least 4 mm.
Embodiment 21. The roofing system according to any of embodiments 14 to 20, wherein at least 75% of the macro-texture has an azimuth angle in a range of 0-45°, 135-225°, and 315-360°.
Embodiment 22. The roofing system according to any of embodiments 14 to 21, wherein a first portion of the macro-texture has an azimuth angle in a range of 150-220° and a second portion of the macro-texture has an azimuth angle in a range of 60-120°, and wherein the size of the second portion is no more than 20% of the size of the first portion.
Embodiment 23. The roofing system according to any of embodiments 14 to 22, wherein a transmission efficiency through the light transmissible front layer at an incident angle of 80° is at least 70%.
Embodiment 24. The roofing system according to any of embodiments 14 to 23, wherein the front layer is formed of glass, e.g., tempered glass.
Embodiment 25. The roofing system according to any of embodiments 14 to 24, wherein the back layer is formed of glass, e.g., tempered glass.
Embodiment 26. The roofing system according to any of embodiments 14 to 25, further comprising a visible coating including a pattern associated with the shape of the photovoltaic cells.
Embodiment 27. The roofing system according to any of embodiments 14 to 26, wherein the visible coating is applied over:
   the rear surface of the front layer,
   the front surface of the back layer, or
   the rear surface of back layer.
Embodiment 28. The roofing system according to embodiment 27, wherein the visible coating is an inorganic enamel coating.
Embodiment 29. The roofing system according to any of embodiments 14 to 28, wherein the roofing panel has a thickness in a range from 3 mm to 15 mm, e.g., from 3 mm to 9 mm.

It will be apparent to those skilled in the art that various modifications and variations can be made to the processes and devices described here without departing from the scope of the disclosure. Thus, it is intended that the present disclosure cover such modifications and variations of this invention provided they come within the scope of the appended claims and their equivalents.

## Claims

1. A roofing panel comprising:
a back layer;
photovoltaic cells disposed over the back layer; and
a light transmissible front layer having a front surface and a rear surface, wherein the front surface includes a surface texture comprising a macro-texture and a micro-texture identified using a roughness filter cut-off of 800 µm, the macro-texture including a plurality of ridges that are substantially aligned with a first direction, and the micro-texture having an arithmetical mean roughness (Ra) of at least 3 µm,
wherein the macro-texture has a texture aspect ratio below 0.05.

2. The roofing panel according to claim 1, wherein the micro-texture has an arithmetical mean roughness (Ra) of at least 5 µm.

3. The roofing panel according to claim 1 or claim 2, wherein an average height of the ridges of the macro-texture is at least 50 µm, e.g., at least 100 µm, e.g. at least 150 µm.

4. The roofing panel according to any of claims 1 to 3, wherein an average width of the ridges of the macro-texture is at least 2 mm, e.g., at least 3 mm, e.g. at least 4mm.

5. The roofing panel according to any of claims 1 to 4, wherein at least 75% of the macro-texture has an azimuth angle in a range of 0-45°, 135-225°, and 315-360°.

6. The roofing panel according to any of claims 1 to 5, wherein a first portion of the macro-texture has an azimuth angle in a range of 150-220° and a second portion of the macro-texture has an azimuth angle in a range of 60-120°, and wherein the size of the second portion is no more than 20% of the size of the first portion.

7. The roofing panel according to any of claims 1 to 6, wherein a transmission efficiency through the light transmissible front layer at an incident angle of 80° is at least 70%.

8. The roofing panel according to any of claims 1 to 7, wherein the front layer is formed of glass, e.g., tempered glass.

9. The roofing panel according to any of claims 1 to 8, wherein the back layer is formed of glass, e.g., tempered glass.

10. The roofing panel according to any of claims 1 to 9, further comprising a visible coating including a pattern associated with the shape of the photovoltaic cells.

11. The roofing panel according to any of claims 1 to 10, wherein the visible coating is applied over:
the rear surface of the front layer,
the front surface of the back layer, or
the rear surface of back layer.

12. The roofing panel according to claim 11, wherein the visible coating is an inorganic enamel coating.

13. The roofing panel according to any of claims 1 to 12, wherein the roofing panel has a thickness in a range from 3 mm to 15 mm, e.g., from 3 mm to 9 mm.

14. A roofing panel system comprising a plurality of roofing panels according to any of claims 1-13 arranged on a support structure.

15. The roofing system according to claim 14, wherein the ridges of the plurality roofing panels extend along a slope of the support structure.
